Europäisches Patentamt

European Patent Office

Office européen des brevets

(19)

(11) Numéro de publication: **0 010 046**
**B1**

(12) **FASCICULE DE BREVET EUROPEEN**

(45) Date de publication du fascicule du brevet: **10.08.83**

(21) Numéro de dépôt: **79400710.4**

(22) Date de dépôt: **05.10.79**

(51) Int. Cl.³: **H 03 H 9/205,** H 03 H 9/10,
H 03 H 9/08, H 04 B 1/03

(54) **Résonateur piézoélectrique.**

(30) Priorité: **09.10.78 FR 7828728**

(43) Date de publication de la demande:
**16.04.80 Bulletin 80/8**

(45) Mention de la délivrance du brevet:
**10.08.83 Bulletin 83/32**

(84) Etats contractants désignés:
**DE GB SE**

(56) Documents cités:
**DE - C - 912 709**
**FR - A - 2 338 607**
**FR - A - 2 353 997**
**US - A - 3 339 091**
**US - A - 3 431 392**
**US - A - 3 978 432**

(73) Titulaire: **ETAT-FRANCAIS représenté par le DELEGUE GENERAL POUR L'ARMEMENT Bureau des Brevets et Inventions de la Délégation Générale pour l'Armement 14, rue Saint-Dominique F-75997 Paris Armées (FR)**

(72) Inventeur: **Besson, Raymond 23 Rue Octave David F-25000 - Besancon (FR)**

(74) Mandataire: **Thevenet, Jean-Bruno et al, Cabinet BEAU DE LOMENIE 55 rue d'Amsterdam F-75008 Paris (FR)**

Courier Press, Leamington Spa, England.

## Résonateur piézoélectrique

La présente invention a pour objet un résonateur piézoélectrique à électrodes non adhérentes au cristal, du type comprenant, montés dans une enceinte étanche, au moins des premier et deuxième plateaux en matériau diélectrique disposés face à face et ecartés l'un de l'autre et sur lesquels sont déposées respectivement des première et deuxième èlectrodes placées en regard d'un corps piézoélectrique interposé entre lesdites première et deuxième électrodes, sans contact avec ces dernières.

Les résonateurs piézoélectriques à électrodes non adhérentes au cristal présentent actuellement un intérêt important dû notamment à la possibilité de réaliser des résonateurs de ce type dotés d'excellentes qualités sur le plan des caractéristiques électrique et mécanique. Des exemples de résonateurs piézoélectriques performants à électrodes non adhérentes au cristal sont décrits notamment dans le document FR—A—2.338.607.

Dans la construction des résonateurs piézoélectriques appelés à être utilisés en particulier dans le domaine aéronautique, on vise constamment à permettre la meilleure insensibilité possible des dispositifs vis à vis notamment des accélérations et des variations de température.

La présente invention vise précisément à réaliser un résonateur dont les stabilités dans le temps sont améliorées et la sensibilité aux accélérations ou aux variations de température est réduite.

Ces buts sont atteints grâce à un résonateur du type mentionné au début qui, conformément à l'invention, comprend en outre un troisième plateau en matériau diélectrique ayant des faces opposées respectivement aux premier et deuxième plateaux sur lesquelles sont déposées respectivement des troisième et quatrième électrodes reliées entre elles, et tel que le corps piézoélectrique est constitué par deux pastilles piézoélectriques en quartz, indépendantes et semblables, dont l'une est interposée entre lesdits première et troisième électrodes, sans contact avec celles-ci, et l'autre est interposée entre les deuxième et quatrième électrodes sans contact avec celles-ci, les pastilles piézoélectriques en quartz étant disposées de telle sorte que leurs axes cristallographiques y'soient opposés.

De préférence, les pastilles de quartz sont en outre disposées de telle sorte que leurs axes cristallographiques Z sont opposés.

Par ailleurs, selon un mode de réalisation intéressant, les pastilles piézoélectriques de quartz sont plan-convexe et présentent leur convexité tournée du côté de leur axe cristallographique y'.

Il est naturellement souhaitable que les pastilles de quartz utilisées soient les plus semblables possibles, c'est à dire constituées en un même matériau, et obtenues par la même technique de coupe. Les performances sont améliorées si par exemple les deux pastilles de quartz proviennent d'un même cristal de base et de zones voisines dans de cristal de base.

L'association de deux pastilles de quartz semblables à l'intérieur d'un même résonateur, le leur disposition avec des axes cristallographiques y' positifs opposés conduisent à la réalisation d'un bi-résonateur dont notamment la sensibilité aux accélérations est réduite d'un facteur de l'ordre de 10 à 20. En outre, les stabilités dans le temps sont améliorées. Par ailleurs, le dispositif reste très compact puisqu'un seul plateau dièlectrique supplémentaire est nécessaire pour supporter les deux électrodes interposées entre les deux pastilles de quartz.

La structure de bi-résonateur définie ci-dessus peut être utilisée de diverses manières avantageuses.

Ainsi, selon une première application, la première partie de résonateur constitué par la première pastille piézoélectrique et les première et troisième électrodes présente une fréquence de résonance sensiblement égale à la fréquence de résonance de la deuxième partie de résonateur constituée par la deuxième pastille piézoélectrique et les deuxième et quatrième électrodes.

Dans ce cas, les première et deuxième parties de résonateur peuvent être connectées soit en série, soit en parallèle.

Selon une autre application, la première partie de résonateur constituée par la première pastille piézoélectrique et les première et troisième électrodes présente une fréquence de résonance très nettement différente de la fréquence de résonance de la deuxième partie de résonateur constituée par la deuxième pastille piézoélectrique et les deuxième et quatrième électrodes, et les première et deuxième parties de résonateur sont montées en paralléle.

Les première et deuxième parties de résonateur peuvent alors présenter des fréquences de résonance qui diffèrent d'au moins environ 5%.

L'utilisation d'un bi-résonateur composé de deux parties de résonateur de fréquences différentes est particulièrement intéressante pour permettre un affranchissement partiquement total de l'influence de la température.

D'une manière générale, il est souhaitable qu'un résonateur piézoélectrique puisse fonctionner à la température d'inversion du cristal piézoélectrique. Il convient ainsi de procéder à un chauffage du résonateur pour l'amener au voisinage de la température d'inversion du cristal. Ce chauffage, réalisé par voie externe, est d'autant plus difficile que la masse de résonateur à chauffer est importante, et que l'atmosphère où se trouve plongé le cristal est inerte.

Conformément à une caractéristique particulière de la présente invention, les pastilles de quartz peuvent être très facilement amenées à une température désirée, et la présence de plateaux diélectriques, loin de constituer un obstacle pour le chauffage du résonateur, offre au contraire un moyen commode pour faciliter la mise en température du résonateur.

Ceci est possible grâce au fait que les premier, deuxième et troisième plateaux sont revêtus, au moins sur leurs faces tournées vers les pastilles piézoélectriques, d'une couche supplémentaire de chauffage en un matériau de résistivité donnée, ladite couche supplémentaire étant reliée à une source d'énergie électrique isolée électriquement des électrodes excitatrices déposées sur les plateaux par une couche d'isolation.

A titre de variante, en remplacement ou en complément du mode de chauffage précédemment décrit, et dans la mesure où le bi-résonateur comprend des bagues périphériques qui entourent respectivement les parties actives des pastilles piézoélectriques disposées entre deux électrodes, et constituent une entretoise entre les plateaux porteurs desdites électrodes, il est possible de revêtir lesdites bagues périphériques de couches de chauffage en un matériau de résistivité donnée et de relier lesdites couches de chauffage à une source d'énergie électrique de manière à réaliser un chauffage radial des pastilles de quartz.

D'autres caractéristiques et avantages de l'invention apparaîtront mieux à la lecture de la description qui fait suite de modes particuliers de réalisation donnés uniquement à titre d'exemples, en référence aux dessins annexés sur lesquels:

— la figure 1 est une vue en coupe axiale d'un bi-résonateur piézoélectrique selon l'invention,
— la figure 2 est un graphique montrant les variations de la fréquence de résonance d'une partie de résonateur en fonction de la température, et
— la figure 3 est une vue éclatée, en coupe axiale, d'un mode particulier de réalisation de bi-résonateur selon l'invention.

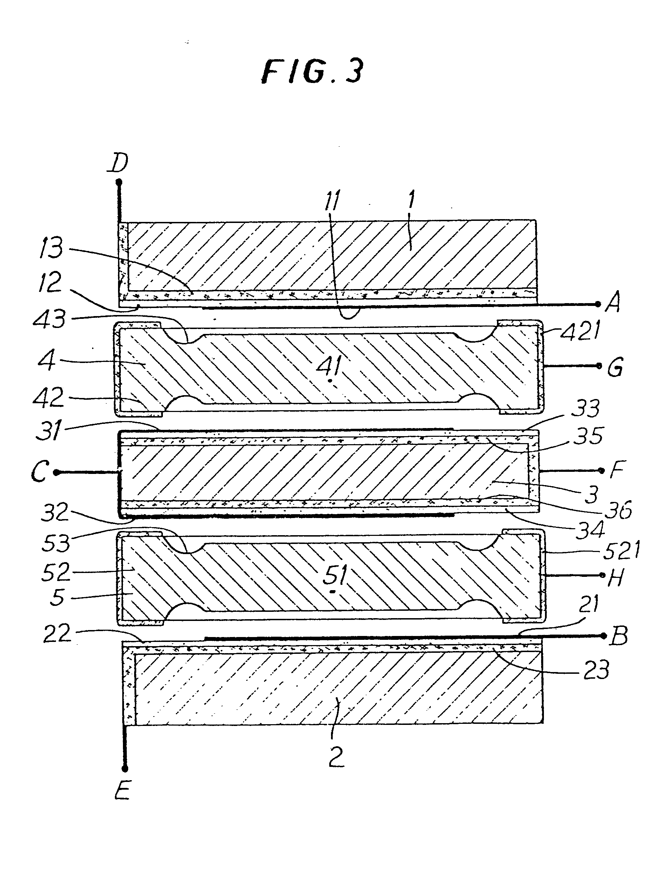

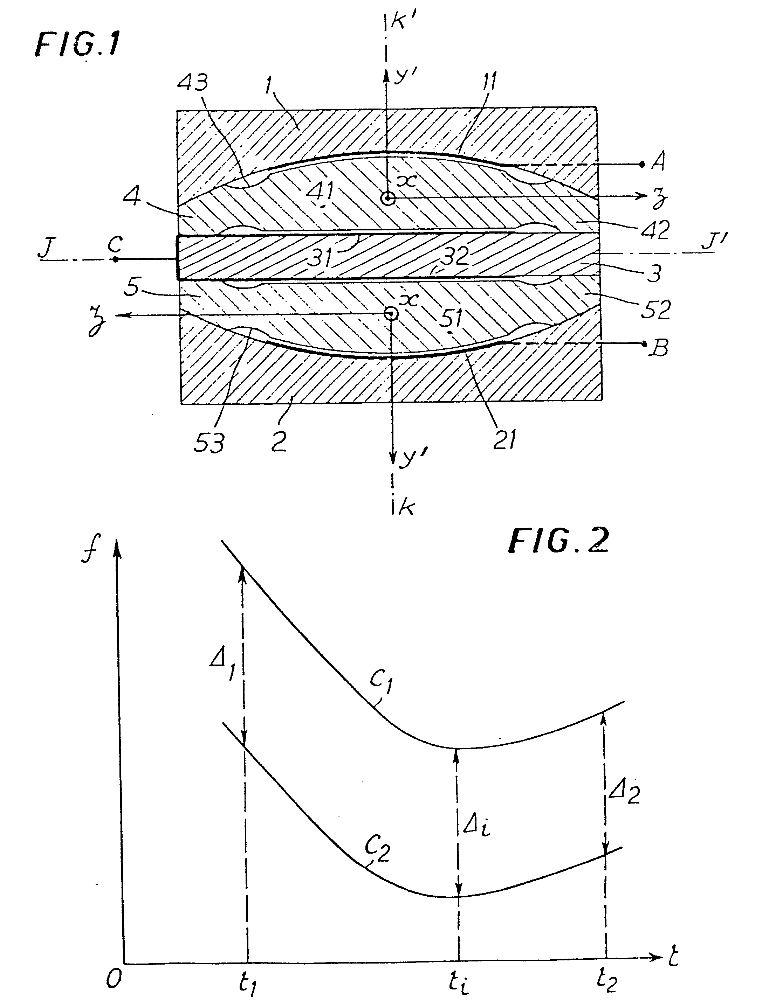

On voit sur la figure 1 un exemple de résonateur piézoélectrique selon l'invention, pour lequel toutefois on n'a pas représenté l'enceinte étanche extérieure, ni les moyens de fixation du bloc fonctionnel à l'intérieur de l'enceinte.

Deux plateaux extérieurs 1 et 2 en matériau diélectrique sont pourvus, sur leurs faces internes, d'électrodes 11 et 21 respectivement, qui sont déposées par métallisation et sont reliées à des bornes de connexion A et B respectivement. Un corps piézoélectrique en deux parties 4, 5 est interposé entre les plateaux 1 et 2. Les pastilles piézoélectriques 4, 5 sont séparées l'une de l'autre par un plateau diélectrique supplémentaire 3 porteur d'électrodes 31, 32 sur ses faces tournées vers les pastilles 4 et 5 respectivement. Les électrodes 31 et 32 sont elles-mêmes connectées à une borne commune C.

La pastille de quartz 4 comprend une partie active vibrante 41 interposée entre les électrodes 11 et 31 et située à très faible distance de ces dernières sans toutefois venir en contact avec elles. De la même manière, la pastille de quartz 5 présente une partie active vibrante 51 interposée entre les électrodes 21 et 32 et située à très faible distance de ces dernières mais sans venir en contact avec celles-ci.

D'une manière générale, la structure apparente d'un bi-résonateur selon l'invention peut être entièrement symétrique par rapport au plan médian J—J' du plateau central 3 et présenter le cas échéant une symétrie de révolution autour de l'axe K—K'. Toutefois, la position relative des deux pastilles de quartz 4, 5 en fonction de leurs axes cristallographiques n'est pas indifférente. Ainsi, le montage des pastilles de quartz 4, 5 doit être réalisé de telle manière que les axes cristallographiques Y' des deux pastilles soient opposés (fig. 1). Dans le cas où les pastilles 4, 5 sont plan-convexe, il est alors avantageux que la convexité sont réalisée dou côté de l'axe Y' positif de chaque pastille, bien que cette condition ne soit pas absolument indispensable.

Par ailleurs, les pastilles de quartz 4, 5 sont de préférence disposées entre le plateaux 1, 2 et 3 de telle manière que les axes cristallographiques Z des deux pastilles de quartz 4, 5 soient opposés. Si les pastilles 4, 5 correspondent toutes deux soit à des cristaux droit, soit à des cristaux gauche, les axes x des pastilles 4, 5 sont alors de même sens (fig. 1).

Le maintien de la partie active 41, 51 des pastilles 4, 5 entres les électrodes 11, 31 et 21, 32 respectivement, peut être réalisé de différentes manières. Selon un mode de réalisation avantageux, représenté sur la figure 1, une pastille 4, 5 comprend une partie 42, 52 en forme de bague qui set d'entretoise pour les plateaux 1 et 3 et 2 et 3 respectivement. La distance entre les différents plateaux est ainsi bien déterminée, et la partie active 41, 51 des pastilles 4, 5 légèrement en retrait par rapport à la partie périphérique de support 42, 52, peut être située à une distance très faible des électrodes 11, 31 ou 21, 32.

Un partie intermédiaire amincie 43, 53 qui peut être évidée sur une partie de la périphérique le la partie active 41, 51 respectivement assure une liaison mécanique et un isolement vibratoire entre la partie active vibrante 41, 51 et la partie support immobile 42, 52. Un tel mode de suspension a été décrit notamment dans le document FR—A—2.338.607.

L'invention n'est toutefois pas limitée à un tel mode de suspension. Ainsi, les parties 42, 52 peuvent être constituées par des bagues indépendantes, tandis que les parties actives 41, 51 sont positionnées par rapport aux plateaux 1, 2 et 3 à l'aide de fixations par thermocompression par exemple.

Plusieurs modes de fonctionnement de bi-résonateur selon l'invention sont possibles. Ainsi, les parties de résonateur constituées par les électrodes 11, 31 et le cristal 41 d'une part, et par les électrodes 21, 32 et le cristal 51 d'autre part, peuvent présenter des fréquences sensiblement égales ou très nettement différentes.

Dans le cas où les deux parties de résonateur 11, 31, 41 et 21, 32, 51 présentent des fréquences de résonance égales ou sensiblement égales, il est possible de prévoir un montage en série, c'est à dire avec l'application d'une tension électrique alternative entre les bornes A et B, la borne C étant déconnectée; ou un montage en parallèle, c'est à dire avec l'application d'une tension électrique alternative entre la borne C et les bornes A et B qui sont alors reliées entre elles. Dans les deux cas, il est alors formé un résonateur unique ou bi-résonateur dont la sensibilité aux accélérations est très nettement réduite par rapport à une résonateur dans lequel ne serait utilisée qu'une seule pastille de quartz. Le bi-résonateur formé présente également des stabilités à court et long terme très améliorées.

Selon un autre type de montage possible, les parties de résonateur 11, 31, 41 et 21, 32, 51 présentent des fréquences de résonance nettement distinctes, par exemple avec une diférence de 1˙ MHz, et ces parties sont montées en parallèle. Dans la mesure où les pastilles de quartz 4 et 5 sont elles mêmes le plus semblabies possibles (même matériau de départ et même type de coupe dans le cristal de base), l'évolution de la fréquence de résonance des parties de résonateur 11, 31, 41 et 21, 32, 51 est indentique. On voit sur la figure 2, l'évolution de la fréquence de la pastille 41 (courbe $C_1$) en fonction de la température et l'évolution de la fréquence de la pastille 51 (courbe $C_2$) également en fonction de la température. Les deux courbes sont partiquement parallèles et par suite, la fréquence différence $\Delta_1$, $\Delta_2$ qui est obtenue à des températures différentes $t_1$, $t_2$ lorsque les parties du résonateur 11, 31, 41 et 21, 32, 51 sont montées en parallèle, est pratiquement indépendante de la température et reste extrêmement proche de la valeur limite $\Delta_i$ obtenue pour la température ti des points d'inversion des pastilles 41, 51. On dispose ainsi d'un systèem dit à chauffage immédiat, c'est à cire opérationnel même avant que la température d'inversion ti soit atteinte.

Comme dans le cas des modes d'utilisation précédents, la sensibilité aux accélérations est également fortement réduite.

On a représenté sur la figure 3, en vue éclatée en coupe, un mode particulier de réalisation de bi-résonateur dans lequel la température d'inversion ti des pastilles de quartz 4, 5 peut de toute manière être obtenue très facilement et rapidement, quelle que soit l'importance de la masse de matériau diélectrique à porter à une température déterminée. Le bi-résonateur de la figure 3 est en effet équipé de moyens de chauffage internes à l'enceinte étanche, non représentée, qui contient les pastilles de quartz 4, 5 et les plateaux 1, 2, 3 porteurs d'électrodes.

Selon le mode de réalisation de la figure 3, des couches d'un matériau de résistivité donnée sont déposées sur les parties non vibrantes du bi-résonateur, notamment sur les plateaux supports d'électrodes à proximité immédiate des parties actives 41, 51 des pastilles de quartz 4, 5. Ainsi, des couches résistives 13, 23 sont déposées sur les plateaux diélectriques 1, 2 respectivement tandis que des couches résistives 35, 36 sont déposées sur le plateau 3. Chaque couche résistive 13, 23, 35, 36 peut être déposée directement sur le plateau diélectrique correspondant, puis recouverte d'une fine couche de matériau isolant, 12, 22, 33, 34 par exemple de SiO, sur laquelle une électrode 11, 21, 31 ou 32 peut alors être déposée. Selon un autre mode de réalisation possible, les électrodes 11, 21, 31 et 32 sont d'abord déposées par métallisation sur les plateaux correspondants 1, 2 et 3, puis de minces couches isolantes 12, 22, 33, 34 sont superposées aux électrodes et recouvertes par les couches conductrices de chauffage 13, 23, 35, 36.

Les couches résistives 13, 23, 35 et 36 sont connectées à des bornes D, E, F respectivement qui permettent le passage d'un courant électrique dans les dites couches résistives pour assurer par effet joule un chauffage, au voisinage immédiat des parties actives 41, 51 des pastilles de quartz 4, 5. On notera que la présence des couches résistives de chauffage, relativement épaisses par rapport aux électrodes notamment, n'affecte pas le coefficient de qualité du résonateur, puisque ces couches sont déposées sur des parties non vibrantes.

Selon une autre caractéristique, des couches résistives de chauffage 421, 521 sont déposées sur les parties 42, 52 respectivement des pastilles 4, 5 qui forment des bagues entretoises de maintien en position de plateaux 1, 2 et 3. Les couches résistives 421, 521 reliées à des sources de courant par les bornes G, H respectivement et permettent un chauffage radial des parties actives 41, 51 des pastilles de quartz 4, 5. Les couches 421, 521 n'affectent pas non plus le coefficient de qualité du bi-résonateur puisqu'elles sont déposées sur des parties immobiles. Il est naturellement possible d'utiliser les couches 421, 521 de façon isolée ou en combinaison avec les couches 13, 23, 35, 36 déposées sur les plateaux 1, 2, 3. Bien entendu, les couches résistives 421, 521 peuvent être déposées aussi bien sur des parties périphériques 42, 52 reliées aux parties 41, 51 que sur les parties périphériques constituées par des bagues indéqentantes.

Les différents modes de réalisation décrits précédemment ne sont donnés qu'à titre indicatif. Ainsi, il serait possible de subdiviser chaque pastille de quartz 4, 5 de nouveau en deux pastilles indépendantes séparées par un plateau diélectrique supplémentair porteur d'électrodes, de façon à améliorer par une connection appropriée des différentes électrodes, certaines performances des résonateurs, sans augmenter sensiblement l'encombrement du dispositif.

En effet, l'adjonction dans un même boitier, d'une pastille de quartz supplémentaire n'entraîne l'adjonction simultanée que d'un seul plateau supplémentaire porteur d'électrodes.

## Revendications

1. Résonateur piézoélectrique à électrodes non adhérentes au cristal, du type comprenant, montés dans une enceinte étanche, au moins un premier et un deuxième plateau en matériau diélectrique disposés face a face et écartés l'un de l'autre et sur lesquels sont disposées respectivement une première et une deuxième électrode placées en regard d'un corps piézoélectrique interposé entre lesdites première et deuxième électrodes, sans contact avec ces dernières, résonateur caractérisé en ce qu'il comprend en outre un troisième plateau (3) en matériau diélectrique ayant des faces opposées respectivement aux premier et deuxième plateaux (1, 2) sur lesquelles sont déposées respectivement des troisième et quatrième électrodes (31, 32) reliées entre elles, et en ce que le corps piézoélectrique est constitué par deux pastilles piézoélectriques (41, 51) et quartz, indépendantes et semblables, dont l'une (41) est interposée entre lesdits première et troisième électrodes (11, 31), sans contact avec celles-ci, et l'autre (51) est interposée entre les deuxième et quatrième électrodes (21, 32) sans contact avec celles-ci, les pastilles piézoélectriques (41, 51) en quartz étant disposées de telle sorte que leurs axes cristallographiques Y' soient opposés.

2. Résonateur piézoélectrique selon la revendication 1, caractérisé en ce que les pastilles de quartz (41, 51) sont en outre disposées de telle sorte que leurs axes cristallographiques z sont opposés.

3. Résonateur selon la revendication 1 ou la revendication 2, caractérisé en ce que les pastilles piézoélectriques de quartz (41, 51) sont plan-convexe et présentent leur convexité tournée du côté de leur axe cristallographique Y'.

4. Résonateur selon l'une des revendications 1 à 3, caractérisé en ce que la première partie du résonateur constituée par la première pastille piézoélectrique (41) et les première et troisième électrodes (11, 31) présente une fréquence de résonance sensiblement égale à la fréquence de résonance de la deuxième partie de résonateur constituée par la deuxième pastille piézoélectrique (51) et les deuxième et quatrième électrodes (21, 32).

5. Résonateur selon la revendication 4, caractérisé en ce que les première (11, 31, 41) et deuxième (21, 32, 51) parties de résonateur sont connectées en parallèle.

6. Résonateur selon la revendication 4, caractérisé en ce que les première (11, 31, 41) et deuxième (21, 32, 51) parties de résonateur sont connectées en série.

7. Résonateur selon l'une des revendications 1 à 3, caractérisé en ce que la première partie de résonateur constituée par la première pastille piézoélectrique (41) et les première et troisième électrodes (11, 31) présente une fréquence de résonance très nettement différente de la fréquence de résonance de la deuxième partie de résonateur constituée par la deuxième pastille piézoélectrique (51) et les deuxième et quatrième électrodes (21, 32) et les première et deuxième parties de résonateur sont montées en parallèle.

8. Résonateur selon la revendication 7, caractérisé en ce que les première (11, 31, 41) et deuxième (21, 32, 51) parties de résonateur présentent des fréquences de résonance qui diffèrent d'au moins environ 5%.

9. Résonateur selon l'une des revendications 1 à 8, caractérisé en ce que le premier (1), deuxième (2) et troisième (3) plateaux sont revêtus, au moins sur leurs faces tournées vers les pastilles piézoélectriques (4, 5), d'une couche supplémentaire de chauffage (13, 23, 35, 36) en un matériau de résistivité donnée, ladite couche supplémentaire étant reliée à une source d'énergie électrique et isolée électriquement des électrodes excitatrices (11, 21, 31, 32) déposées sur les plateaux par une couche d'isolation (12, 22, 33, 34).

20. Résonanteur selon l'une des revendications 1 à 9, du type comprenant des bagues périphériques qui entourent respectivement les parties actives des pastilles piézoélectriques disposées entre deux électrodes, et constituent une entretoise entre les plateaux porteurs des dites électrodes, caractérisé en ce que lesdites bagues périphériques (42, 52) sont revêtues de couches de chauffage (421, 521) en un matériau de résistivité donnée, ledites couches de chauffage étant reliées à une source d'énergie électrique.

## Patentansprüche

1. Piezoelektrischer Resonator mit nicht am Kristall anhaftenden Elektroden, welcher in einem dichten Gehäuse gelagert, zumindest eine erste und eine zweite Platte aus dielektrischem Material umfaßt, die einander gegenüber und voneinander im Abstand angeordnet sind und auf welchen sich eine erste bzw. eine zweite Elektrode befinden, die gegenüber einem zwischen der ersten und der zweiten Elektrode eingesetzten, mit letzteren nacht in Kontakt stehenden piezoelektrischen Körper vorgesehen sind, dadurch gekennzeichnet, daß der Resonator weiters eine dritte Platte (3) aus dielektrischem Material mit der ersten bzw. zweiten Platte (1, 2) augekehrten Flächen umfaßt, auf denen eine dritte bzw. mit dieser verbundene vierte Elektrode (31, 32) vorgesehen sind, und daß der piezoelektrische Körper durch zwei unabhängige und gleichartige piezoelektrische Scheiben (41, 51) aus Quarz gebildet ist, von denen eine (41) zwischen der ersten und dritten Elektrode (11, 31), ohne Kontakt mit denselben, eingesetzt ist und die andere (51) zwischen der zweiten und vierten Elektrode (21, 32), ohne Kontakt mit denselben, eingesetzt ist, wobei die piezoelektrischen Scheiben (41, 51) aus Quarz derart angeordnet sind, daß ihre kristallografischen Achsen Y' entgegengesetzt gerichtet sind.

2. Piezoelektrischer Resonantor nach Anspruch 1, dadurch gekennzeichnet, daß die Scheiben (41, 51) aus Quarz weiters derart angeordnet sind, daß ihre kristallografischen Z-Achsen entgegengesetzt gerichtet sind.

3. Piezoelektrischer Resonator nach Anspruch 1 oder 2, dadurch gekennzeichnet, daß die piezoelektrischen Scheiben (41, 51) aus Quarz plankonvex sind, wobei ihre Konvexität zur Seite ihrer kristallografischen Y'-Achse gerichtet ist.

4. Resonator nach einem der Ansprüche 1 bis 3, dadurch gekennzeichnet, daß der durch die erste piezoelektrische Scheibe (41) und die erste und dritte Elektrode (11, 31) gebildete erste Resonatortèil eine Resonanzfrequenz aufweist, die im wesentlichen gleich der Resonanzfrequenz des zweiten, durch die zweite piezoelektrische Scheibe (51) und die zweite und vierte Elektrode (21, 32) geglideten Responatorteils ist.

5. Resonator nach Anspruch 4, dadurch gekennzeichnet, daß der erste (11, 31, 41) und zweite (21, 31, 51) Resonatorteil parallelgeschaltet sind.

6. Responator nach Anspruch 4, dadurch gekennzeichnet, daß der erste (11, 31, 41) und zweite (21, 32, 51) Resonatorteil in Serie geschaltet sind.

7. Resonator nach einem der Ansprüche 1 bis 3, dadurch gekennzeichnet, daß der erste, durch die erste piezoelektrische Scheibe (41) und die erste und dritte Elektrode (11, 31) gebildete Resonatorteil eine Resonanzfrequenz aufweist, die sich sehr deutlich von der Resonanzfrequenz des zweiten, durch die zweite piezoelektrische Scheibe (51) und die zweite und vierte Elektrode (21, 32) gebildeten Resonatorteils unterscheidet, und daß der erste und zweite Resonatorteil parallelgeschaltet sind.

8. Resonator nach Anspruch 7, dadurch gekennzeichnet, daß der erste (11, 31, 41) und zweite (21, 32, 51) Resonatorteil Resonanzfrequenzen aufweisen, die um zumindest etwa 5% voneinander abweichen.

9. Resonator nach einem der Ansprüche 1 bis 8, dadurch gekennzeichnet, daß die erste (1), zweite (2) und dritte (3) Platte zumindest auf ihren den piezoelektrischen Scheiben (4, 5) zugekehrten Flächen mit einer zusätzlichen Heizschicht (12, 23, 35, 36) aus einem Material von gegebenem Leitungswiderstand überzogen sind, welche zusätzliche Schicht mit einer elektrischen Energiequelle verbunden und von den auf den Platten angeordneten Erregerelektroden (11, 21, 31, 32) durch eine Isolierschicht (12, 22, 33, 34) elektrisch isoliert sind.

10. Resonator nach einem der Ansprüche 1 bis 9 mit Umfangsringen die jeweils die aktiven Teile der zwischen zwei Elektroden angeordneten piezoelektrischen Scheiben umgeben und eine Trennwand zwischen den Trägerplatten der Elektroden bilden, dadurch gekennzeichnet, daß die Umfangsringen (42, 52) mit Heizschichten (421, 521) aus einem Material von gegebenem Leitungswiderstand überzogen sind, welche Heizschichten mit einer elektrischen Energiequelle verbunden sind.

**Claims**

1. A piezoelectric resonator with electrodes not adhering to the crystal, of the type comprising, mounted in a sealed enclosure, at least a first and a second plate made of a dielectric material placed in facing relation but separated one from the other, on which are deposited respectively a first and a second electrodes placed opposite a piezoelectric body interposed between said first and second electrodes, without contact therewith, said resonator being characterized in that it further comprises a third plate (3) in dielectric material provided with faces opposed to the first and second plates (1, 2) respectively, and on which are respectively deposited third and fourth interconnected (31, 32) electrodes, and the piezoelectric body is constituted by two piezoelectric chips (41, 51) made of quartz, independent and similar, one (41) of which is interposed between the said first and third electrodes (11, 31), without contact therewith, and the other (51) is interposed between the second and fourth electrodes (21, 32) without contact therewith, the quartz piezoelectric chips (41, 51) being arranged so that their crystallographic axes Y' are opposite.

2. A resonator according to Claim 1, characterized in that the quartz chips (41, 51) are also arranged so that their crystallographic axes z are opposite.

3. A resonator according to Claim 1 or 2, characterized in that the piezoelectric quartz chips (41, 51) are flat-convex and their convexity is directed towards their crystallographic axis Y'.

4. A resonator according to any one of Claims 1 to 3, characterized in that the first resonator part constituted by the first piezoelectric chip (41) and the first and third electrodes (11, 31) has a resonance frequency which is substantially equal to the resonance frequency of the second resonator part constituted by the second piezoelectric chip (51) and the second and fourth electrodes (21, 32).

5. A resonator according to Claim 4, characterized in that the first (11, 31, 41) and second (21, 32, 51) responator parts are connected in parallel.

6. A resonator according to Claim 4, characterized in that the first (11, 31, 41) and second (21, 32, 51) resonator parts are connected in series.

7. A resonator according to any one of Claims 1 to 3, characterized in that the first resonator part constituted by the first piezoelectric chip (41) and the first and third electrodes (11, 31) has a resonance frequency which is clearly different from the resonance frequency of the second resonator part constituted by the second piezoelectric chip (51) and the second and fourth electrodes (21, 32) and the first and second resonator parts are mounted in parallel.

8. A resonator according to Claim 7, characterized in that the first (11, 31, 41) and second (21, 32, 51) resonator parts have resonance frequencies which differ by about 5% at least.

9. A resonator according to any one of Claims 1 to 8, characterized in that the first (1), second (2) and third (3) plates are coated, at least on their faces directed towards the piezoelectric chips (4, 5) with an extra heating layer (13, 23, 35, 36) of a material of given resistivity, said extra layer being connected to an electric power source and being electrically insulated from the energizing electrodes (11, 21, 31, 32) deposited on the plates by an insulating layer (12, 22, 33, 34).

10. A resonator according to any one of Claims 1 to 9, of the type comprising peripheral rings which respectively surround the active portions of the piezoelectric chips disposed between two electrodes and constitute a spacer between the plates carrying the said electrodes, characterized in that the said peripheral rings (42, 52) are coated with heating layers (421, 521) of a material of given resistivity, said heating layers being connected to an electric power source.

# FIG. 3

FIG.1

FIG.2